# EUROPEAN PATENT SPECIFICATION

(11) **EP 2 481 576 B1**
(45) Date of publication and mention of the grant of the patent: **24.05.2017**
(21) Application number: 09849670.6
(22) Date of filing: 25.09.2009
(51) Int. Cl.: B32B 17/06, C03C 14/00, C03C 17/00, C03C 27/06, C09K 11/02

(54) **LUMINESCENT GLASS, PRODUCING METHOD THEREOF AND LUMINESCENT DEVICE**
LUMINESZENZGLAS, HERSTELLUNGSVERFAHREN UND LUMINESZENZVORRICHTUNG
VERRE LUMINESCENT, SON PROCÉDÉ DE PRODUCTION ET DISPOSITIF LUMINESCENT ASSOCIÉ

(43) Date of publication of application: 01.08.2012
(73) Proprietor: Ocean's King Lighting Science & Technology Co., Ltd., Shenzhen, Guangdong 518054 (CN)
(72) Inventor: ZHOU, Mingjie, Shenzhen Guangdong 518054 (CN); MA, Wenbo, Shenzhen Guangdong 518054 (CN)
(74) Representative: Potter Clarkson LLP
(86) International application number: PCT/CN2009/074242
(87) International publication number: WO 2011/035482

(56) References cited:
- CN-A- 1 603 265
- CN-A- 101 186 436
- CN-A- 101 468 878
- US-A1- 2005 274 967
- US-A1- 2009 206 352

## Description

### TECHNICAL FIELD

The present invention relates to the technical field of luminescent devices, and specifically to a luminescent glass with glass as the luminescent matrix, the producing method thereof and a luminescent device.

### BACKGROUND ART

Conventional materials used as the luminescent matrix include fluorescent powder, nano-crystals, glass, and the like. Compared to the crystals and fluorescent powder, glass has received wide attention and is used in many applications, as it is transparent and rigid, has good chemical stability and good optical properties, and is easier to be made into products with various sizes or shapes, such as displays or light sources with various sizes or shapes.

The luminescent glass may be used in a variety of luminescent devices, such as LED light sources, liquid crystal display, flat panel display, plasma display, and the like. LED (light-emitting diode) exhibits a great commercial potential and a broad application prospect in the aspects of solid-state illumination due to its advantages such as long service life, high energy efficiency, environment-friendliness, etc. LED is becoming the fourth generation of light sources, following the incandescent lamps, the fluorescent lamps and the gas discharge lamps. However, the properties of the white LED currently-used in liquid crystal display (LCD) cannot satisfy the requirements of general illumination. As the luminous flux of one single LED chip is too low, hundreds of white LEDs are required for fulfilling the luminous flux requirements of general illumination. The most general method for solving this problem is to increase the output power of LED. This method makes it possible to increase the luminous flux of one single LED chip, but it would increase the temperature of the blue LED chip at the same time, which would result in degradation of resins coated on the blue LED chip, leading to decreases in luminous efficiency and service life. Moreover, in the conventional method of encapsulating resins with fluorescent powder, the coating of the fluorescent powder is not uniform, resulting in uneven light-emitting and poor luminescent effects.

In order to solve the above problems, a microcrystal glass fluorophor for white LED was developed. The microcrystal glass has excellent stability. When this material is used for LED encapsulation, the white LED may work for a long time without shift in color coordinates. Decreases in luminous efficiency and service life are also alleviated greatly. However, the process for manufacturing said microcrystal glass is complex. Specifically, it is difficult to control the annealing process parameters for the crystallization of the glass. As a result, the microcrystal glass fluorophor for white LED is difficult to be commercialized. Consequently, it is suggested to mix fluorescent powder with low-melting point glass powder, and to melt to prepare glass blocks at a temperature higher than 1000°C, so as to dope the fluorescent powder into the glass directly. However, during this preparation process, the fluorescent powder may react with the glass matrix, leading to severe deterioration of the fluorescent property of the fluorescent powder.

CN101468878 describes a molded fluorescent glass lens and a manufacturing method which comprises coating fluorescent material onto the surface of a glass preform or the surface of a mold cavity of a mold core; heating and pressurizing the mold core so as to cast the glass preform into the molded fluorescent glass lens; pressing and filtrating fluorescent material into the glass to form a fluorescent external surface layer.

US2009/0206352 describes a luminescent conversion LED having a radiation emitting chip that is connected to electrical connections and is surrounded by a housing that comprises at least a basic body and a cap.

### DISCLOSURE OF THE INVENTION

### Technical Problem

For the above reasons, the present invention provides a luminescent glass with good luminescence reliability, high luminescence stability and long service life, and a luminescent device comprising said luminescent glass.

The present invention further provides a method for manufacturing the luminescent glass, which can be carried out at a relative low temperature and improves the luminescence reliability and stability.

### Technical Solution

The present invention provides a luminescent glass comprising a glass matrix, wherein said glass matrix comprises at least two layers of glass parts and at least one layer of a complex part which comprises glass materials and fluorescent powder dispersed in said materials, and said at least one layer of the complex part of glass and fluorescent powder is embedded into each layer of the glass parts; wherein said fluorescent powder comprises a fluorescent material which can be excited by violet lights.

The present invention also provides a method for manufacturing a luminescent glass according to the present invention, comprising the following steps:
- providing a first glass plate and a second glass plate;
- applying a fluorescent powder to a surface of the first glass plate to form a fluorescent powder layer, wherein the fluorescent powder comprises a fluorescent material which can be excited by violet lights.
- placing the second glass plate on the fluorescent powder layer, so that the fluorescent powder layer is located between the two glass plates;
- heating to soften the glass plates, so that the fluorescent powder is dispersed in a part of each glass plate to form a glass part and a complex part of glass and fluorescent powder which is embedded in and binds to the glass part, and to form an integrated luminescent glass after solidification.

The present invention further provides a luminescent device, which comprises said luminescent glass and an encapsulation body for encapsulating said luminescent glass.

### Beneficial Effects

In the luminescent glass and the luminescent device, as the complex part of glass and fluorescent powder is embedded in and binds to the glass part, the glass part can well protect the fluorescent powder therein from being affected by the external environment, such as the humidity. Moreover, the glass has good air-impermeability and chemical stability, which improves the luminescence reliability and stability of the luminescent glass and the luminescent device. Furthermore, the deterioration of the fluorescent property of the fluorescent powder can be avoided, and the service life of the luminescent glass and the luminescent device can be prolonged. In the manufacturing process, the fluorescent powder and the glass plate are heated together to soften, so that the fluorescent powder is dispersed in a part of the glass plate. Therefore, it is only required to control the heating temperature at the softening temperature of the glass, while melting at high temperatures is not required. During the heating process, the fluorescent powder may be doped into the softened glass and integrated therewith. The whole process does not degrade the fluorescent powder, which increases the luminescence reliability and stability of the resultant luminescent glass, and avoids the fluorescent glue from being degraded by the high temperature or illumination after traditional glue-dispensing process. Furthermore, during the whole process, no complex devices or process parameter adjustments are required. Thus, the manufacturing process, as a whole, can be simply operated with high efficiency.

### BRIEF DESCRIPTION OF THE DRAWINGS

The present invention will be described in more details with reference to the following drawings and examples, wherein:
Figure 1 is a flow chart of a method for manufacturing a luminescent glass described herein for reference.
Figure 2 is a schematic flow diagram of the method for manufacturing luminescent glass in accordance to Example 1 of the present invention;
Figure 3 is a schematic flow diagram of the method for manufacturing luminescent glass in accordance to Example 2 of the present invention; and
Figure 4 is a schematic diagram of a luminescent device comprising the luminescent glass manufactured according to Figure 1 described herein.

### DETAILED DESCRIPTION OF THE EMBODIMENTS

For further illustrating the purposes, technical solutions and advantages of the present invention, the invention will be described in more details with reference to the drawings and examples. It should be understood that the examples are provided for illustrating rather than limiting the present invention.

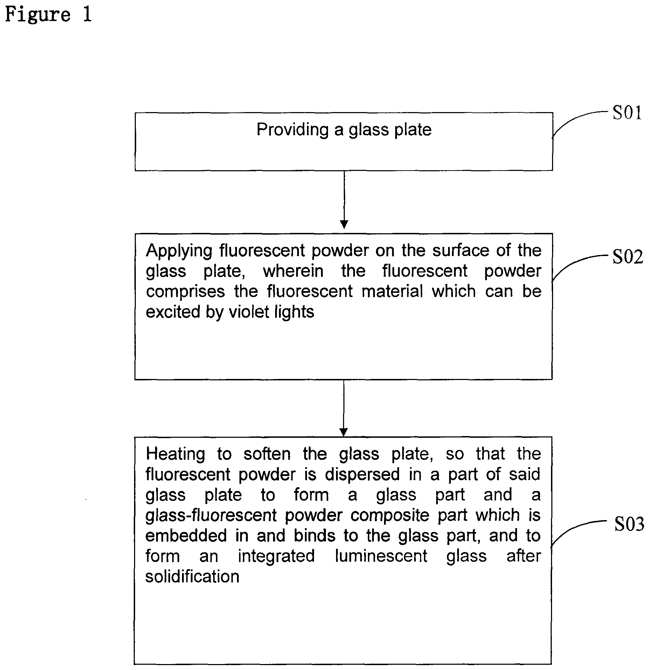

Referring to Figure 1 showing the flow chart of a method for manufacturing a luminescent glass, the method comprising the following steps:
S01: providing a glass plate;
S02: applying fluorescent powder on the surface of the glass plate, wherein the fluorescent powder comprises a fluorescent material which can be excited by violet lights; and
S03: heating to soften the glass plate, so that the fluorescent powder is dispersed in a part of said glass plate to form a glass part and a complex part of glass and fluorescent powder which is embedded in and binds to the glass part, and to form an integrated luminescent glass after solidification.

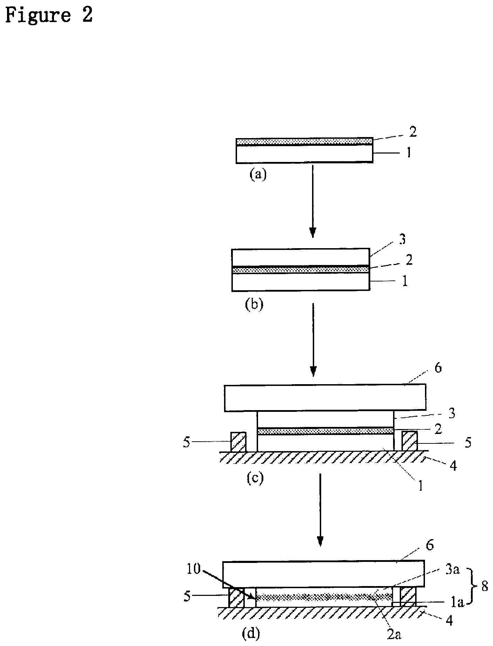

As shown in Figure 2, this example provides a first glass plate 1 and a second glass plate 3. In this case, steps S02 to S03 may be the steps as shown in the figure, specifically as follows:
Formation of a fluorescent-powder layer: applying fluorescent powder on the surface of a first glass plate 1 to form a fluorescent-powder layer 2, wherein the fluorescent powder comprises a fluorescent material which can be excited by violet lights;
Lamination: placing a second glass plate 3 on the fluorescent-powder layer 2, so that the fluorescent-powder layer 2 is located between the glass plates 1 and 3; and
Heating to soften and molding: heating to soften each of the glass plates 1 and 3, so that the fluorescent powder is dispersed in each of the glass plates 1 and 3, to form an integrated luminescent glass 10 after solidification.

In the step for forming the fluorescent-powder layer (Figure 2(a)), the thickness of the first glass plate may be in the range of 0.3 mm to 3 mm, preferably in the range of 0.5 mm to 1 mm. As the first glass plate, a variety of suitable low-melting-point glass may be used, for example, but not limited to, borosilicate glass, such as Na₂O-ZnO-B₂O₃-SiO₂. The glass with the suitable material may have a softening temperature in the range of 200°C to 800°C, preferably 200°C to 600°C. The thickness of the fluorescent-powder layer is 5 to 80 micrometers, preferably in the range of 10 to 40 micrometers. The fluorescent powder may comprise at least one of the fluorescent materials of the three primary colors which can be excited by violet lights. For example, the fluorescent powder may be blue fluorescent material, green fluorescent material, yellow fluorescent material, red fluorescent material which can be effectively excited by violet LED, or any combination thereof, wherein the blue fluorescent powder may be selected from Sr₅(PO₄)₃Cl:Eu, ZnS:Ag, BaMgAl₁₀O₁₇:Eu, and the like; the green fluorescent powder may be selected from ZnS:Cu, Ca₈Mg(SiO₄)₄Cl₂:Eu,Mn, BaMgAl₁₀O₁₇:Eu,Mn, and the like; the yellow fluorescent powder may be selected from YAG:Ce, TAG:Ce, and the like; and the red fluorescent powder may be selected from Y₂O₂S:Eu and the like. These materials may be commercially available, for example, from Dalian Luming Optoelectronics Engineering Co., Ltd. Where the weight ratio of the fluorescent materials with red color, green color, and blue color, respectively, is (5~25) : (1~2) : (0.5~1), a white light is obtained. In one embodiment, a combined fluorescent powder is used, wherein blue Sr₅(PO₄)₃Cl:Eu fluorescent powder, green Ca₈Mg(SiO₄)₄Cl₂:Eu,Mn fluorescent powder and red Y₂O₂S:Eu fluorescent powder are mixed in a weight ratio of 1 : 2 : 25. It shall be understood, however, that the combinations of the fluorescent materials with different colors and weight ratio may be selected according to actual requirements, and are not limited to the examples provided herein.

The fluorescent-powder layer may be formed by coating or depositing or spraying or the like, such as coating on the surface of the first glass plate 1 through screen printing process. By adopting this well-developed screen printing process, the industrial mass production of the fluorescent glass can be realized and the production efficiency may be greatly increased.

Additionally, the first glass plate 1 may be subjected to pretreatment. For example, it may be firstly cut into desired shape and then ground and polished. In an embodiment, the thickness of the first glass plate is set to 0.5 mm, and then manufactured into glass plate 1 with uniform shape.

In the lamination step (Figure 2(b)), the fluorescent-powder layer 2 is set between the glass plates 1 and 3, wherein the second glass plate 3 and the first glass plate 1 may have the same or different glass materials, depending on the actual requirement. In this example, the second glass plate 3 has substantially the same structure, size and material as the first glass plate 1, and is also subjected to the pretreatment and other treatments. When different materials are used for the first and the second glass plates, the first glass plate 1 and the second glass plate 3 may be different in size or structure, or either one of them may be doped with specific chemical materials (such as rare earth elements) or may have different colors for satisfying different requirements. Therefore, according to the manufacturing method of this example, a fluorescent glass having at least two layers of different materials with different sizes or different dopants may be prepared, which would have been impossible in the prior art.

During the heating/softening process, the heating temperature is 200°C to 800°C which is kept for 0.5 to 5 hours. Preferably, the total thickness of all the glass plates is further adjusted to control the thickness of the resultant fluorescent glass. Meanwhile, each of all the glass plates may be pressed for dispersing the fluorescent powder into each glass plate. In an embodiment, as shown in Figure 2(c), during the heating/softening process, a pressing block 6 with a certain weight may be placed on the second glass plate 3 to simultaneously press the first glass plate 1 and the second glass plate 3. The pressing block 6 may be a piece of flat glass or a flat metal plate. For conveniently adjusting the pressing pressure, an object with a predetermined mass, such as a weight, may be added on the plate. The first glass plate 1 is placed on a platform, such as on a flat metal plate 4. A height-adjustable blocker 5 is placed around or at opposite sides of the first glass plate 1 and the second glass plate 3 to control the final thickness of the integrated fluorescent glass 10 formed from the heated/softened glass plates 1 and 3 under the pressure of the pressing block 6. Then, the integrated structure as shown in Figure 2(c) is placed into an electric furnace, heated to 530°C, and kept for 90 min to soften the glass plates 1 and 3. Under the pressure of the pressing block 6, the glass plates 1 and 3 bind to each other, with the fluorescent powder being doped therein. After the final cooling and solidification process, the first glass plate 1 and the second glass plate 3 form a glass matrix 8, and an integrated fluorescent glass 10 comprising fluorescent powder therein is thus obtained, as shown in Figure 2(d).

As shown in Figure 2(d), in the fluorescent glass 10, the glass matrix 8 comprises two layers of glass parts 1 a and 3a corresponding to the first glass plate 1 and the second glass plate 3; and a complex part of glass and fluorescent powder 2a is formed from the fluorescent-powder layer 2 embedded in the first glass place 1 and the second glass plate 3. The complex part of glass and fluorescent powder 2a is embedded in and binds to the two glass parts 1 a and 3a, and is substantially located in the central areas. The complex part of glass and fluorescent powder 2a comprises glass materials and fluorescent powder dispersed in said glass materials. The glass materials are the materials of the first glass plate 1 and the second glass plate 3, which may be the same or different.

Additionally, it can be understood that only the first glass plate 1 may be used with the fluorescent-powder layer 2 formed thereon. Subsequently, the fluorescent-powder layer 2 is covered with a metal plate or a mold. Alternatively, the first glass plate 1 with the fluorescent-powder layer 2 formed thereon is turned upside-down and placed on the metal plate 4, rendering the fluorescent-powder layer 2 to contact with the metal plate 4, which is then subjected to the subsequent steps, so as to form a fluorescent glass prepared from one glass plate. Consequently, the resultant fluorescent glass comprises one glass part and a complex part of glass and fluorescent powder embedded in the glass part.

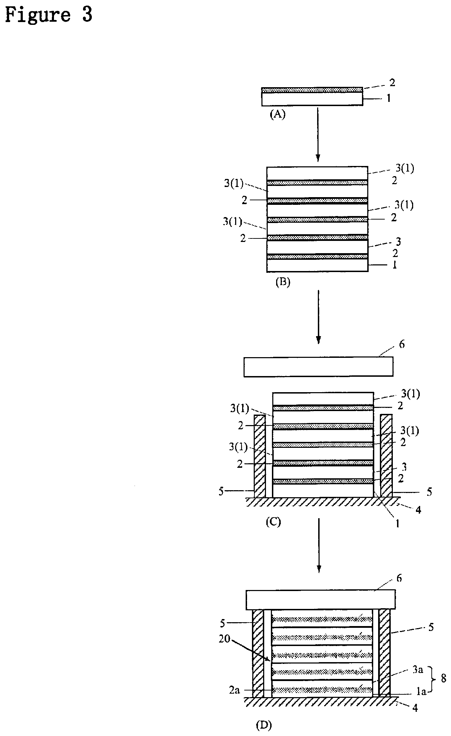

Figure 3 is the flow diagram of the method for manufacturing luminescent glass in accordance to Example 2 of the present invention, and shows the structure in each step. In this example, the method comprises every steps of Example 1 (shown in Figure 2), and the difference lies in that the step for forming the fluorescent-powder layer and the subsequent lamination step are repeated after the first lamination step, so as to form a multi-layered glass plate/fluorescent powder-sandwiched structure, as shown in Figure 3(B). As shown in the figure, each glass plates 1 and 3 are arranged alternately with the fluorescent-powder layer 2. The figure exhibits an example with five fluorescent-powder layers 2. Additionally, each of the repeated glass plates may be selected from the first glass plate 1 or the second glass plate 3, depending on the actual requirement. Additionally, the first glass plate 1 and the second glass plate 3 may be the same or different in their sizes, materials or dopants; and the fluorescent-powder layers 2 may be different in their thicknesses, sizes, materials or other components, so as to diversify the product of the fluorescent glass. In addition, the fluorescent powder in each layer may be a mixture of yellow YAG:Ce fluorescent material with red Y₂O₂S:Eu fluorescent material in a weight ratio of 4:1. In some embodiments, in the laminating step, each layer of fluorescent powder may comprise different luminescent material. For example, without limitation, fluorescent materials with B (blue), G (green), R (red), G (green), B (blue) colors may be sequentially aligned from the top down.

As shown in Figures 3(C) and 3(D), the steps are similar to the steps of Example 1 except that the object to be heated and pressed is the glass composite with multi-layered structure, and thus are not described in details. After cooling and solidification process, an integrated glass matrix is formed from the glass plates, and a fluorescent glass 20 comprising multiple layers of dispersed fluorescent powder is thus obtained.

According to the above method, by controlling the thickness of the fluorescent powder to be coated and the number of the glass plates to be laminated, the doping rate of the fluorescent powder, thickness and transmittance of the final fluorescent glass may be controlled. In addition, the ratio of the fluorescent materials with three colors in the combined fluorescent powder may be controlled to obtain white lights with different color temperatures and color-rendering indexes.

The structure of the fluorescent glass 20 prepared in this example is substantially the same as that of the fluorescent glass 10 except for the number of the layers. The same elements are marked with the same reference signs in Figures 3 and 2, and thus are not described in details. As shown in Figure 3(D), in the fluorescent glass 20, the glass matrix 8 comprises multiple-layered glass parts 1a and 3a corresponding to the plural first glass plates 1 and second glass plates 3; and multiple layers of fluorescent powder 2 are embedded in the corresponding first glass plates 1 and the second glass plates 3 to form multiple layers of the complex part of glass and fluorescent powder 2a. The multiple layers of the complex part of glass and fluorescent powder 2a are embedded in and bind to the corresponding multiple layers of the glass parts 1 a and 3a, respectively, wherein each complex part of glass and fluorescent powder 2a comprises glass materials and fluorescent powder dispersed in said glass materials.

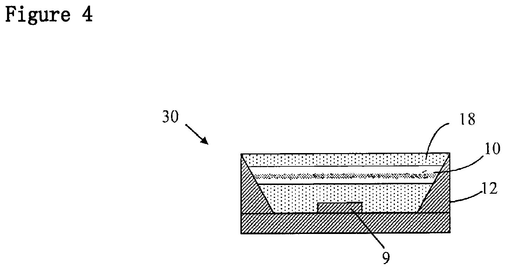

The fluorescent glasses 10 and 20 prepared in the examples of the present invention are shown in Figures 2(d) and 3(D). As described above, the glass plates are heated to soften and solidified to form a glass matrix. In an embodiment, the glass matrix has an integrated structure. When the glass plates are of the same material, the glass matrix is a whole glass body. When the glass plates are of different materials, the glass matrix is a glass body made from different materials. According the above methods, the fluorescent powder is substantially dispersed in the central part of the glass matrix, i.e., within the area adjacent to where the glass plates bind to each other. The fluorescent glass 10 and 20 may be used in a variety of luminescent devices, such as LED light sources, liquid crystal display, flat panel display, plasma display, and the like. All of these luminescent devices comprise said fluorescent glass 10 or 20 and an encapsulation body for encapsulating the fluorescent glass 10 or 20. As shown in Figure 4, a luminescent device 30 comprises fluorescent glass 10 and an encapsulation body 18 (such as silica gel or epoxy resin) for encapsulating the fluorescent glass 10. The encapsulation body 18 further encapsulates an LED chip 9, and is assembled in a reflecting cup 12. When the blue light emitted from the LED chip enters the fluorescent glass 10, the fluorescent powder therein is excited to emit light to go through the encapsulation body 18.

In the above methods, the glass plates 1 and 3 may be selected flexibly. The selected glass material may have high transmittance and good machinability. The glass may also have air-impermeability and chemical stability to protect the YAG:Ce fluorescent powder dispersed therein from the humidity in the air, and to avoid the deterioration of the fluorescent property of the fluorescent powder. Due to the low softening point of said glass, the heat resistance of YAG:Ce fluorescent powder is sufficient to withstand the temperature for integrating the glass by heating to soften, and thus the heating/softening process will not lead to the deterioration of the fluorescent property of the YAG:Ce fluorescent powder.

In the fluorescent glass and the luminescent device, the complex part of glass and fluorescent powder 2a is embedded in and binds to the glass parts 1 a and 3a. Therefore, the glass parts 1a and 3a can well protect the YAG:Ce fluorescent powder from being affected by the external environment, such as the humidity. Moreover, the glass has good air-impermeability and chemical stability, and thus improves the luminescence reliability and stability of the fluorescent glass and the luminescent device, and can avoid the deterioration of the fluorescent property of the fluorescent powder, and prolong the service life of the luminescent glass and luminescent device. In the manufacturing process, the fluorescent powder and the glass plate are heated to soften, so as to disperse the fluorescent powder in a part of the glass plate. Therefore, it is only required to control the heating temperature at the softening temperature of the glass, while melting at high temperatures is not required. During the heating process, the fluorescent powder may be doped into the softened glass and integrated therewith. The whole process does not degrade the fluorescent powder, which increases the luminescence reliability and stability of the resultant luminescent glass, and avoids the fluorescent glue from being degraded by the high temperature or illumination after traditional glue-dispensing process. Furthermore, during the whole process, no complex devices or process parameter adjustments are required. Thus, the manufacturing process, as a whole, can be simply operated with high efficiency. The examples as described above are preferred embodiments for carrying out the invention rather than limiting the scope of the present invention.

## Claims

1. A luminescent glass comprising a glass matrix, wherein said glass matrix comprises at least two layers of glass parts and at least one layer of a complex part which comprises glass materials and fluorescent powder dispersed in said materials, and said at least one layer of the complex part of glass and fluorescent powder is embedded into each layer of the glass parts; wherein said fluorescent powder comprises a fluorescent material which can be excited by violet lights.

2. The luminescent glass according to claim 1, **characterized in that** said at least two layers of glass parts comprise the same or different materials.

3. A method for manufacturing a luminescent glass according to claim 1, comprising the following steps:
- providing a first glass plate and a second glass plate;
- applying a fluorescent powder to a surface of the first glass plate to form a fluorescent powder layer, wherein the fluorescent powder comprises a fluorescent material which can be excited by violet lights;
- placing the second glass plate on the fluorescent powder layer, so that the fluorescent powder layer is located between the two glass plates;
- heating to soften the glass plates, so that the fluorescent powder is dispersed in a part of each glass plate to form a glass part and a complex part of glass and fluorescent powder which is embedded in and binds to the glass part, and to form an integrated luminescent glass after solidification.

4. The method according to claim 3, **characterized in that**, after the step for placing the fluorescent powder layer between the two glass plates, the step for forming the fluorescent powder layer and the subsequent step of placing a glass plate on the fluorescent powder layer, so that the fluorescent powder layer is located between the two glass plates are repeated, so as to form a multi-layered glass plate/fluorescent powder-sandwiched structure; the multi-layered structure is then heated to soften to form a luminescent glass with a multi-layered structure of complex parts of glass and fluorescent powder embedded between layers of glass plates.

5. The method according to claim 3, **characterized in that** the thickness of each glass plate is 0.3 to 3 mm; and the thickness of the fluorescent-powder layer is 5 to 80 micrometers.

6. The method according to claim 3, **characterized in that** the fluorescent-powder layer is formed on the surface of the first glass plate by screen printing, depositing or spraying.

7. The method according to claim 3, **characterized in that** the total thickness of all the glass plates is further adjusted during the step of heating to soften to control the thickness of the resultant fluorescent glass.

8. The method according to claim 3, **characterized in that** all the glass plates are further pressed during the step of heating to soften for embedding the fluorescent powder into each glass plate.

9. The method according to claim 3, **characterized in that** the temperature during the heating process is 200°C to 800°C which is kept for 0.5 to 5 hours.

10. A luminescent device comprising a luminescent glass according to claim 1 and an encapsulating body for encapsulating the luminescent glass.

## Patentansprüche

1. Lumineszenzglas, umfassend eine Glasmatrix, wobei die Glasmatrix wenigstens zwei Schichten aus Glasteilen und wenigstens eine Schicht aus einem komplexen Teil, umfassend Glasmaterialien und in den Materialien verteiltes Fluoreszenzpulver, umfasst und wobei die wenigstens eine Schicht aus dem komplexen Teil aus Glas und Fluoreszenzpulver in jede Schicht der Glasteile eingebettet ist, wobei das Fluoreszenzpulver ein fluoreszierendes Material umfasst, das durch violettes Licht angeregt werden kann.

2. Lumineszenzglas nach Anspruch 1, **dadurch gekennzeichnet, dass** die wenigstens zwei Schichten aus Glasteilen dasselbe oder verschiedene Materialien umfassen.

3. Verfahren zum Erzeugen eines Lumineszenzglases nach Anspruch 1,
die folgenden Schritte umfassend:
- Bereitstellen einer ersten Glasplatte und einer zweiten Glasplatte;
- Auftragen eines Fluoreszenzpulvers auf eine Oberfläche der ersten Glasplatte, um eine Fluoreszenzpulverschicht auszubilden, wobei das Fluoreszenzpulver ein fluoreszierendes Material umfasst, das durch violettes Licht angeregt werden kann;
- Anordnen der zweiten Glasplatte auf der Fluoreszenzpulverschicht, sodass die Fluoreszenzpulverschicht zwischen den zwei Glasplatten angeordnet ist;
- Erwärmen der Glasplatten, um sie weich zu machen, sodass das Fluoreszenzpulver in einem Teil jeder Glasplatte verteilt wird, um einen Glasteil und einen komplexen Teil aus Glas und Fluoreszenzpulver, der in dem Glasteil eingebettet und an diesen gebunden ist, auszubilden, und um nach dem Erstarren ein einstückiges Lumineszenzglas auszubilden.

4. Verfahren nach Anspruch 3, **dadurch gekennzeichnet, dass** nach dem Schritt zum Platzieren der Fluoreszenzpulverschicht zwischen den zwei Glasplatten der Schritt zum Ausbilden der Fluoreszenzpulverschicht und der darauffolgende Schritt des Anordnens einer Glasplatte auf der Fluoreszenzpulverschicht, sodass die Fluoreszenzpulverschicht sich zwischen den zwei Glasplatten befindet, wiederholt werden, um eine mehrschichtige Glasplatten-Fluoreszenzpulver-Sandwichanordnung auszubilden, wobei die mehrschichtige Anordnung dann zum Weichmachen erwärmt wird, um ein Lumineszenzglas mit einer mehrschichtigen Anordnung aus komplexen Teilen aus Glas und Fluoreszenzpulver, eingebettet zwischen Schichten aus Glasplatten, auszubilden.

5. Verfahren nach Anspruch 3, **dadurch gekennzeichnet, dass** die Dicke jeder Glasplatte 0,3 bis 3 mm beträgt und die Dicke der Fluoreszenzpulverschicht 5 bis 80 µm beträgt.

6. Verfahren nach Anspruch 3, **dadurch gekennzeichnet, dass** die Fluoreszenzpulverschicht durch Siebdruck, Ablagern oder Aufsprühen auf der Oberfläche der ersten Glasplatte ausgebildet wird.

7. Verfahren nach Anspruch 3, **dadurch gekennzeichnet, dass** die Gesamtdicke aller Glasplatten ferner im Schritt des Erwärmens zum Weichmachen angepasst wird, um die Dicke des sich ergebenden Fluoreszenzglases zu kontrollieren.

8. Verfahren nach Anspruch 3, **dadurch gekennzeichnet, dass** alle Glasplatten ferner im Schritt des Erwärmens zum Weichmachen zusammengepresst werden, um das Fluoreszenzpulver in jede Glasplatte einzubetten.

9. Verfahren nach Anspruch 3, **dadurch gekennzeichnet, dass** die Temperatur während des Erwärmungsvorgangs 200 °C bis 800 °C beträgt und 0,5 bis 5 Stunden lang gehalten wird.

10. Lumineszenzvorrichtung, umfassend ein Lumineszenzglas nach Anspruch 1 und einen Einkapselungskörper zum Einkapseln des Lumineszenzglases.

## Revendications

1. Verre luminescent comprenant une matrice vitreuse, dans lequel ladite matrice vitreuse comprend au moins deux couches de parties de verre et au moins une couche d'une partie complexe qui comprend des matériaux de verre et une poudre fluorescente dispersée dans lesdits matériaux, et ladite au moins une couche de la partie complexe de verre et de poudre fluorescente est incorporée dans chaque couche des parties de verre ; dans lequel ladite poudre fluorescente comprend un matériau fluorescent qui peut être excité par des lumières violettes.

2. Verre luminescent selon la revendication 1, **caractérisé en ce que** lesdites au moins deux couches de parties de verre comprennent les mêmes matériaux ou des matériaux différents.

3. Procédé de fabrication d'un verre luminescent selon la revendication 1, comprenant les étapes suivantes :
- la fourniture d'une première plaque de verre et d'une seconde plaque de verre ;
- l'application d'une poudre fluorescente à une surface de la première plaque de verre pour former une couche de poudre fluorescente, dans lequel la poudre fluorescente comprend un matériau fluorescent qui peut être excité par des lumières violettes ;
- le placement de la seconde plaque de verre sur la couche de poudre fluorescente, de sorte que la couche de poudre fluorescente soit située entre les deux plaques de verre ;
- le chauffage pour ramollir les plaques de verre, de sorte que la poudre fluorescente soit dispersée dans une partie de chaque plaque de verre pour former une partie de verre et une partie complexe de verre et de poudre fluorescente qui est incorporée et se lie à la partie de verre, et pour former un verre luminescent intégré après solidification.

4. Procédé selon la revendication 3, **caractérisé en ce que**, après l'étape de placement de la couche de poudre fluorescente entre les deux plaques de verre, l'étape de formation de la couche de poudre fluorescente et l'étape ultérieure de placement d'une plaque de verre sur la couche de poudre fluorescente, de sorte que la couche de poudre fluorescente soit située entre les deux plaques de verre, sont répétées de façon à former une structure intercalée multicouche de plaque de verre/poudre fluorescente ; la structure multicouche est ensuite chauffée pour se ramollir afin de former un verre luminescent avec une structure multicouche de parties complexes de verre et de poudre fluorescente incorporée entre des couches de plaques de verre.

5. Procédé selon la revendication 3, **caractérisé en ce que** l'épaisseur de chaque plaque de verre est de 0,3 à 3 mm ; et l'épaisseur de la couche de poudre fluorescente est de 5 à 80 micromètres.

6. Procédé selon la revendication 3, **caractérisé en ce que** la couche de poudre fluorescente est formée sur la surface de la première plaque de verre par sérigraphie, dépôt ou pulvérisation.

7. Procédé selon la revendication 3, **caractérisé en ce que** l'épaisseur totale de toutes les plaques de verre est en outre ajustée pendant l'étape de chauffage pour ramollir afin de réguler l'épaisseur du verre fluorescent résultant.

8. Procédé selon la revendication 3, **caractérisé en ce que** toutes les plaques de verre sont en outre comprimées pendant l'étape de chauffage pour ramollir afin d'incorporer la poudre fluorescente dans chaque plaque de verre.

9. Procédé selon la revendication 3, **caractérisé en ce que** la température pendant le processus de chauffage est de 200 °C à 800 °C, laquelle température est maintenue pendant 0,5 à 5 heures.

10. Dispositif luminescent comprenant un verre luminescent selon la revendication 1 et un corps d'encapsulation pour encapsuler le verre luminescent.
